# EUROPÄISCHE PATENTSCHRIFT

(11) **EP 2 887 515 B1**
(45) Veröffentlichungstag und Bekanntmachung des Hinweises auf die Patenterteilung: **18.07.2018**
(21) Anmeldenummer: 14195855.3
(22) Anmeldetag: 02.12.2014
(51) Int. Cl.: H02M 1/00, H02M 1/08, H02M 3/155, H02M 3/335, H03K 17/795, H02H 3/05, H02M 1/32, H02H 7/08, H02M 3/156

(54) **Steuergerät**
Control unit
Appareil de commande

(30) Priorität: 02.12.2013 DE 102013224674
(43) Veröffentlichungstag der Anmeldung: 24.06.2015
(73) Patentinhaber: Schmidhauser AG, 8590 Romanshorn (CH)
(72) Erfinder: Burgermeister, Andreas, 8576 Mauren (CH)
(74) Vertreter: Patentanwälte Ruff, Wilhelm, Beier, Dauster & Partner mbB

(56) Entgegenhaltungen:
- EP-A2- 2 495 869
- Scott Wayne: "iCoupler Digital Isolators Protect RS-232, RS-485, and CAN Buses in Industrial, Instrumentation, and Computer Applications", , 1. Oktober 2005 (2005-10-01), Seite 1, XP055226933, Gefunden im Internet: URL:http://www.analog.com/library/analogDi alogue/archives/39-10/iCoupler.pdf [gefunden am 2015-11-09]
- "Isolated, Precision Half-Bridge Driver, 0.1 A Output Data Sheet ADuM1233", , 1. Januar 2006 (2006-01-01), XP055226945, Gefunden im Internet: URL:http://www.analog.com/media/en/technic al-documentation/data-sheets/ADUM1233.pdf [gefunden am 2015-11-09]
- "ISO5500 2.5-A Isolated IGBT, MOSFET Gate Driver 1 Features 3 Description 2 Applications @BULLET Isolated IGBT and MOSFET Drives in Functional Block Diagram - Motor Control - Motion Control - Industrial Inverters - Switched-Mode Power Supplies", , 2. September 2011 (2011-09-02), XP055226952, Gefunden im Internet: URL:http://www.ti.com/lit/ds/symlink/iso55 00.pdf [gefunden am 2015-11-09]

## Beschreibung

Die Erfindung betrifft ein Steuergerät zur Ansteuerung eines Elektromotors, beispielsweise ein Steuergerät in Form eines Frequenzumrichters oder eines Servo-Reglers, insbesondere mit Safe-Torque-Off-Funktion.

Steuergeräte mit Safe-Torque-Off-Funktion überwachen üblicherweise ein erstes und ein zweites Aktuatorsignal an zugehörigen Aktuatorsignal-Anschlüssen. Nur wenn beide Aktuatorsignale einen zulässigen Betriebszustand signalisieren, beispielsweise jeweils einen Pegel von 24 V aufweisen, wird die Erzeugung einer hochfrequenten Betriebsspannung für den Elektromotor freigegeben, d.h. es kann ein Antriebsdrehmoment mittels des Elektromotors erzeugt werden.

Die EP 2 495 869 A2 zeigt ein Steuergerät zur Ansteuerung eines Elektromotors, aufweisend eine Anzahl von Leistungshalbleitern zur Erzeugung von Ansteuersignalen für den Elektromotor, eine Anzahl von Treibern, die dazu ausgebildet sind, Ansteuersignale für die Leistungshalbleiter zu erzeugen, wobei die Treiber mittels einer Treiber-Versorgungsspannung versorgt sind, deren Vorhandensein Voraussetzung dafür ist, dass die Treiber ihr jeweiliges Ansteuersignal mit einem Zustand erzeugen, das einen zugehörigen Leistungshalbleiter leitend schaltet, und einen Oszillator, der dazu ausgebildet ist, ein Oszillatorsignal zu erzeugen, wobei der Oszillator mittels einer Oszillator-Versorgungsspannung versorgt ist, deren Vorhandensein Voraussetzung dafür ist, dass der Oszillator das Oszillatorsignal erzeugt.

Der Erfindung liegt die Aufgabe zugrunde, ein Steuergerät zur Ansteuerung eines Elektromotors zur Verfügung zu stellen, das eine hohe Betriebssicherheit aufweist und das insbesondere in einem Fehlerfall sicher verhindert, dass mittels des Elektromotors ein Drehmoment erzeugt wird.

Die Erfindung löst diese Aufgabe durch ein Steuergerät nach Anspruch 1. Bevorzugte Ausführungsformen sind Gegenstand der Unteransprüche, die hiermit durch Bezugnahme zum Inhalt der Beschreibung gemacht werden.

Das Steuergerät ist zur Ansteuerung eines Elektromotors ausgebildet. Bei dem Elektromotor kann es sich beispielsweise um einen herkömmlichen dreiphasigen Synchron- oder Asynchronmotor handeln.

Das Steuergerät weist eine Anzahl von Leistungshalbleitern zur Erzeugung von Ansteuersignalen für den Elektromotor auf. Das Steuergerät kann beispielsweise sechs insulated-gate bipolar Transistoren (IGBTs) aufweisen, wobei jeweils zwei der IGBTs eine herkömmliche Brückenschaltung bilden, und drei pulsweitenmodulierte Ansteuersignale für einen herkömmlichen Drehstrommotor erzeugen.

Das Steuergerät weist weiter eine Anzahl von Treibern auf, beispielsweise sechs Treiber, die dazu ausgebildet sind, Ansteuersignale für die Leistungshalbleiter zu erzeugen. Die Treiber sind jeweils mittels einer Treiber-Versorgungsspannung versorgt, deren Vorhandensein mit ausreichendem Pegel Voraussetzung dafür ist, dass die Treiber ihr jeweiliges Ansteuersignal mit einem Zustand erzeugen können, das einen zugehörigen Leistungshalbleiter leitend schaltet. Die Treiber-Versorgungsspannung ist eine Gleichspannung.

Das Steuergerät weist weiter einen Oszillator auf, der dazu ausgebildet ist, ein Oszillatorsignal zu erzeugen, wobei der Oszillator mittels einer Oszillator-Versorgungsspannung versorgt ist, deren Vorhandensein mit ausreichendem Pegel Voraussetzung dafür ist, dass der Oszillator das Oszillatorsignal erzeugen kann. Das Oszillatorsignal kann beispielsweise eine Rechteckspannung sein, beispielsweise mit einer Frequenz im Bereich zwischen einigen kHz bis einigen MHz. Die Oszillator-Versorgungsspannung ist eine Gleichspannung.

Das Steuergerät weist weiter einen Aufwärtswandler auf, der dazu ausgebildet ist, aus einer Aufwärtswandler-Eingangsspannung die Treiber-Versorgungsspannung zu erzeugen. Die Aufwärtswandler-Eingangsspannung ist eine Gleichspannung. Der Aufwärtswandler weist mindestens ein steuerbares Schaltmittel mit einem Steuereingang und einem Schaltausgang auf. Steuerbar bedeutet, dass ein Schaltzustand des Schaltausgangs, d.h. offen (nicht leitend) oder geschlossen (leitend), mittels eines Signals am Steuereingang einstellbar ist. Das steuerbare Schaltmittel weist eine galvanische Trennung zwischen Steuereingang und Schaltausgang auf, wobei der Steuereingang mit dem Oszillatorsignal beaufschlagt ist, so dass der Schaltausgang im Takt des Oszillatorsignals abwechselnd offen (nicht leitend) oder geschlossen (leitend) ist.

Das steuerbare Schaltmittel kann ein Optokoppler sein. Alternativ kann das steuerbare Schaltmittel ein kapazitiver Koppler oder ein induktiver Koppler sein, wobei der Schaltzustand des Schaltausgangs kapazitiv bzw. induktiv gesteuert wird.

Das Steuergerät kann ein Stromrichter oder ein Servo-Regler mit Safe-Torque-Off-Funktion sein. Die Safe-Torque-Off-Funktion bezeichnet den so genannten sichereren Halt bei Frequenzumrichtern und Servo-Reglern. Im Übrigen sei insoweit auch auf die einschlägige Fachliteratur verwiesen.

Die Treiber-Versorgungsspannung kann einen Gleichspannungspegel zwischen 12 V und 30 V aufweisen und die Aufwärtswandler-Eingangsspannung kann einen Gleichspannungspegel von weniger als 10 V aufweisen.

Der Aufwärtswandler kann ein so genannter Boost-Wandler (Boost Converter) mit einer Drossel sein. Der Aufwärtswandler kann alternativ ein Sperrwandler mit einem Übertrager sein. Im Übrigen sei bezüglich der Wandler-Topologien auch auf die einschlägige Fachliteratur verwiesen.

Die Erfindung wird nachfolgend unter Bezugnahme auf die Zeichnungen detailliert beschrieben. Hierbei zeigen schematisch:
- Fig. 1: ein Blockschaltbild eines Steuergeräts zur Ansteuerung eines Elektromotors und
- Fig. 2: eine alternative Ausführungsform eines Aufwärtswandlers für das in Fig. 1 gezeigte Steuergerät.

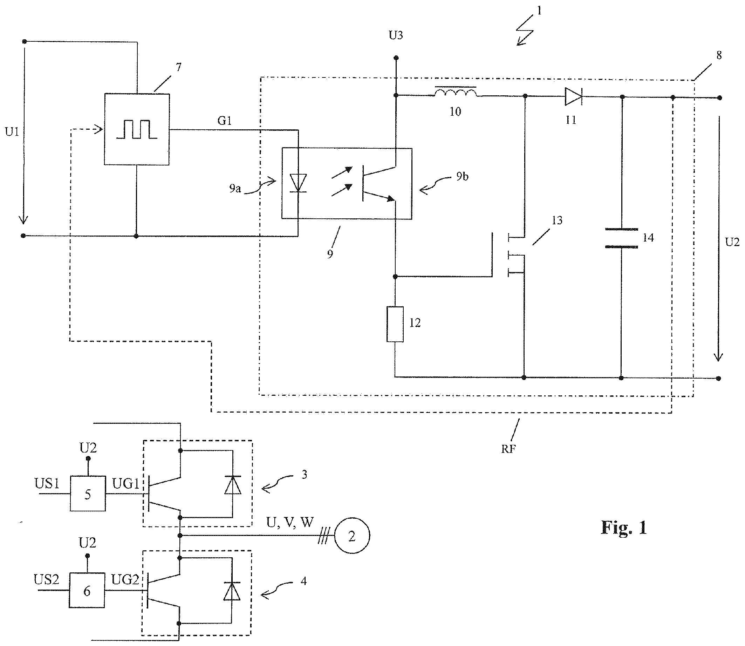

Fig. 1 zeigt ein Blockschaltbild eines Steuergeräts 1 in Form eines Stromrichters oder eines Servo-Reglers mit Safe-Torque-Off-Funktion zur Ansteuerung eines dreiphasigen Elektromotors 2.

Das Steuergerät 1 weist eine Anzahl von Leistungshalbleitern 3, 4 zur Erzeugung von herkömmlich pulsweitenmodulierten Ansteuersignalen U, V, W für den Elektromotor 2 auf. Insgesamt weist das Steuergerät 1 sechs Leistungshalbleiter auf, wobei exemplarisch für lediglich eine der Phasen die Leistungshalbleiter 3, 4 dargestellt sind. Leistungsstufen für die verbleibenden Phasen sind entsprechend aufgebaut.

Das Steuergerät 1 weist weiter eine Anzahl von Treibern 5, 6 auf, die dazu ausgebildet sind, Ansteuersignale UG1, UG2 für die Leistungshalbleiter 3, 4 in Abhängigkeit von herkömmlichen PWM-Ansteuersignalen US1 und US2 zu erzeugen. Die PWM-Ansteuersignale US1 und US2 werden herkömmlich von einer nicht näher dargestellten Steuereinheit erzeugt. Insgesamt weist das Steuergerät 1 sechs Treiber auf, wobei exemplarisch für lediglich eine der Phasen die Treiber 5, 6 dargestellt sind. Treiber für die verbleibenden Phasen sind entsprechend aufgebaut.

Die Treiber 5, 6 sind mittels einer Treiber-Versorgungsspannung U2 versorgt, deren Vorhandensein Voraussetzung dafür ist, dass die Treiber 5, 6 ihr jeweiliges Ansteuersignal UG1, UG2 mit einem Zustand erzeugen können, das einen zugehörigen Leistungshalbleiter 3, 4 leitend schaltet.

Mit anderen Worten ist die Treiber-Versorgungsspannung U2 nicht vorhanden bzw. weist keinen ausreichenden Pegel auf, sind die Treiber 5, 6 nicht dazu in der Lage, ihr jeweiliges Ansteuersignal UG1, UG2 derart zu erzeugen, insbesondere mit einem solchen Pegel zu erzeugen, dass der zugehörige Leistungshalbleiter 3, 4 leitet. Wenn die Treiber-Versorgungsspannung U2 vorhanden ist bzw. einen ausreichenden Pegel aufweist, werden die Ansteuersignale UG1, UG2 in Anhängigkeit von den PWM-Ansteuersignalen US1 und US2 erzeugt, wobei die Leistungshalbleiter 3, 4 in Abhängigkeit vom Zustand bzw. Pegel der PWM-Ansteuersignale US1 und US2 entweder leiten oder sperren. Die Treiber-Versorgungsspannung U2 kann beispielsweise einen Pegel zwischen 12 V und 30 V aufweisen.

Das Steuergerät 1 weist weiter einen Oszillator 7 auf, der dazu ausgebildet ist, ein Oszillatorsignal G1 in Form einer Rechteckspannung zu erzeugen, wobei der Oszillator 7 mittels einer Oszillator-Versorgungsspannung U1 versorgt ist, deren Vorhandensein Voraussetzung dafür ist, dass der Oszillator 7 das Oszillatorsignal G1 erzeugen kann. Die Oszillator-Versorgungsspannung U1 kann von einer externen Steuereinheit als ein Safe-Torque-Signal bereitgestellt werden.

Das Steuergerät 1 weist weiter einen Aufwärtswandler 8 in Form eines Boost-Converters auf, der dazu ausgebildet ist, aus einer Aufwärtswandler-Eingangsspannung U3 mit einem Pegel von beispielsweise 6V die Treiber-Versorgungsspannung U2 zu erzeugen.

Der Aufwärtswandler 8 weist ein steuerbares Schaltmittel 9 in Form eines Optokopplers auf. Der Optokoppler 9 weist herkömmlich einen Steuereingang 9a und einen Schaltausgang 9b auf, insoweit sei auch auf die einschlägige Fachliteratur verwiesen. Der Steuereingang 9a des Optokopplers 9 ist mit dem Oszillatorsignal G1 beaufschlagt.

Der Schaltausgang 9b und ein Widerstand 12 sind in Reihe zwischen die Aufwärtswandler-Eingangsspannung U3 und ein Bezugspotential der Treiber-Versorgungsspannung U2, beispielsweise Masse, eingeschleift.

Ein Verbindungsknoten des Schaltausgangs 9b mit dem Widerstand 12 ist elektrisch mit einem Gate-Anschluss eines Transistors 13 elektrisch verbunden.

Eine Drossel 10 und eine Drain-Source-Strecke des Transistors 13 sind in Reihe zwischen die Aufwärtswandler-Eingangsspannung U3 und das Bezugspotential eingeschleift.

Eine Diode 11 und ein Kondensator 14 sind als Reihenschaltung der Drain-Source-Strecke des Transistors 13 parallel geschaltet, wobei am Kondensator 14 die Treiber-Versorgungsspannung U2 anliegt.

Zur Regelung der Treiber-Versorgungsspannung U2 ist eine optionale Rückführung RF der Treiber-Versorgungsspannung U2 beispielsweise zum Oszillator 7 möglich, wobei der Oszillator 7 für diesen Fall beispielsweise ein Tastverhältnis des Oszillatorsignals G1 als Stellgröße derart nachführt, dass sich ein gewünschter Pegel der Treiber-Versorgungsspannung U2 einstellt.

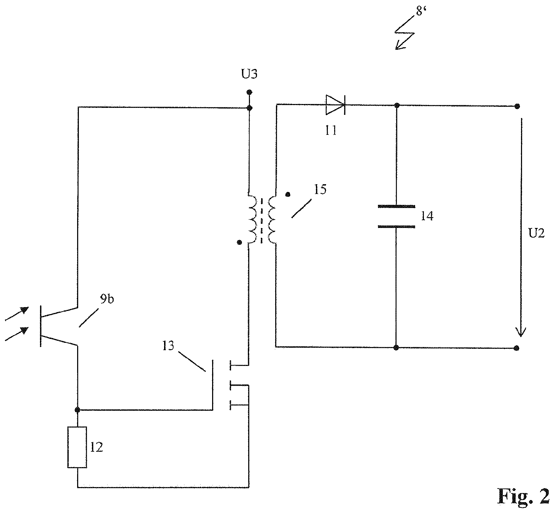

Fig. 2 zeigt eine alternative Ausführungsform eines Aufwärtswandlers 8' für das in Fig. 1 gezeigte Steuergerät 1.

Der Aufwärtswandler 8' ist als Sperrwandler mit einem Übertrager 15 ausgeführt.

Eine Primärwicklung des Übertragers 15 und die Drain-Source-Strecke des Transistors 13 sind in Reihe zwischen die Aufwärtswandler-Eingangsspannung U3 und das Bezugspotential eingeschleift.

Die Diode 11 und der Kondensator 14 sind als Reihenschaltung der Sekundärwicklung des Übertragers 15 parallel geschaltet, wobei am Kondensator 14 die Treiber-Versorgungsspannung U2 anliegt.

Erfindungsgemäß wird die Spannung U2, üblicherweise ca. 24V, für die Gatetreiber 5, 6 mittels eines Boostconverters 8 aus einer niedrigeren Spannung U3 erzeugt, wobei der Boostconverter 8 über ein galvanisch trennendes Element getaktet bzw. angesteuert wird.

Hierzu speist die Oszillator-Versorgungsspannung U1, als ein von einer externen Steuerung erzeugtes STO-Signal, den Oszillator 7, der wiederum den Optokoppler 9 ansteuert. Somit beginnt der Oszillator 7 erst zu schwingen, wenn U1 einen entsprechenden Pegel überschreitet.

Der Optokopplerausgang 9b steuert einen elektronischen Schalter 13 an, beispielsweise in Form eines MOSFET, der bei der in Fig. 1 gezeigten Ausführungsform zusammen mit der Drossel 10 und der Diode 11 einen Boostconverter 8 darstellt. Auf diese Weise wird eine interne Speisung U3, von z.B. 6 V, auf eine Spannung von z.B. 24 V erhöht, die dann zur Speisung der Gatetreiber 5 verwendet wird. Entsprechendes gilt für den Boostconverter 8' aus Fig. 2.

Liegt irgendwo in der Schaltung ein Defekt vor, so sinkt U2 auf unter 6V und die Gatetreiber 5, 6 schalten ab, beziehungsweise die IGBTs 3, 4 haben zu wenig Ansteuerspannung.

Das erfindungsgemäße Steuergerät 1 ist kostengünstig herstellbar, weist eine geringe Verlustleistung auf und ist mit geringem Platzbedarf realisierbar, da kein Übertrager über der Isolationsstrecke notwendig ist.

Das erfindungsgemäße Steuergerät 1 weist weiter eine hohe Zuverlässigkeit und Sicherheit auf, da ein Kurzschluss in der Schaltung durch Bauteilfehler oder Fremdkörper systematisch nicht zum Anlaufen des Motors 2 führen kann. Sobald ein oder mehrere Defekte vorliegen, arbeitet der Boostconverter 8 nicht mehr und die Spannung U2 am Ausgang sinkt, so dass sich ein sicherer Zustand einstellt.

## Patentansprüche

1. Steuergerät (1) zur Ansteuerung eines Elektromotors (2), aufweisend:
- eine Anzahl von Leistungshalbleitern (3, 4) zur Erzeugung von Ansteuersignalen (U, V, W) für den Elektromotor (2),
- eine Anzahl von Treibern (5, 6), die dazu ausgebildet sind, Ansteuersignale (UG1, UG2) für die Leistungshalbleiter (3, 4) zu erzeugen, wobei die Treiber (5, 6) mittels einer Treiber-Versorgungsspannung (U2) versorgt sind, deren Vorhandensein Voraussetzung dafür ist, dass die Treiber (5, 6) ihr jeweiliges Ansteuersignal (UG1, UG2) mit einem Zustand erzeugen, das einen zugehörigen Leistungshalbleiter (3, 4) leitend schaltet, und
- einen Oszillator (7), der dazu ausgebildet ist, ein Oszillatorsignal (G1) zu erzeugen, wobei der Oszillator (7) mittels einer Oszillator-Versorgungsspannung (U1) versorgt ist, deren Vorhandensein Voraussetzung dafür ist, dass der Oszillator (7) das Oszillatorsignal (G1) erzeugt,
**dadurch gekennzeichnet, dass** das Steuergerät (1) aufweist:
- einen Aufwärtswandler (8), der dazu ausgebildet ist, aus einer Aufwärtswandler-Eingangsspannung (U₃), deren Pegel nicht ausreichend ist um die Leistungshalbleiter leitend zu schalten, die Treiber-Versorgungsspannung (U2) zu erzeugen, wobei der Aufwärtswandler (8) mindestens ein steuerbares Schaltmittel (9) mit einem Steuereingang (9a) und einem Schaltausgang (9b) aufweist, wobei das steuerbare Schaltmittel (9) eine galvanische Trennung zwischen Steuereingang (9a) und Schaltausgang (9b) aufweist, wobei der Steuereingang (9a) mit dem Oszillatorsignal (G1) beaufschlagt ist.

2. Steuergerät (1) nach Anspruch 1, **dadurch gekennzeichnet, dass** das steuerbare Schaltmittel (9) ein Optokoppler ist.

3. Steuergerät (1) nach Anspruch 1, **dadurch gekennzeichnet, dass** das steuerbare Schaltmittel (9) ein kapazitiver Koppler oder ein induktiver Koppler ist.

4. Steuergerät (1) nach einem der vorhergehenden Ansprüche, **dadurch gekennzeichnet, dass** das Steuergerät (1) ein Stromrichter oder ein Servo-Regler mit Safe-Torque-Off-Funktion ist.

5. Steuergerät (1) nach einem der vorhergehenden Ansprüche, **dadurch gekennzeichnet, dass** die Treiber-Versorgungsspannung (U2) einen Pegel zwischen 12 V und 30 V aufweist und die Aufwärtswandler-Eingangsspannung (U3) einen Pegel von weniger als 10 V aufweist.

6. Steuergerät (1) nach einem der vorhergehenden Ansprüche, **dadurch gekennzeichnet, dass** der Aufwärtswandler ein Boost-Wandler ist.

7. Steuergerät (1) nach einem der Ansprüche 1 bis 5, **dadurch gekennzeichnet, dass** der Aufwärtswandler ein Sperrwandler ist.

## Claims

1. Control unit (1) for controlling an electric motor (2), comprising:
- a number of power semiconductors (3, 4) for generating control signals (U, V, W) for the electric motor (2),
- a number of drivers (5, 6) configured to generate control signals (UG1, UG2) for the power semiconductors (3, 4), wherein the drivers (5, 6) are powered by a driver supply voltage (U2), the presence of said driver supply voltage (U2) being a prerequisite to allow that the drivers (5, 6) generate their respective control signals (UG1, UG2) with a condition that switches an associated power semiconductor (3, 4) to conductivity, and
- an oscillator (7) configured to generate an oscillator signal (G1), wherein the oscillator (7) is powered by an oscillator supply voltage (U1), the presence of said oscillator supply voltage (U1) being a prerequisite to allow that the oscillator (7) generates the oscillator signal (G1),
**characterized in that** the control unit (1) comprises:
- a step-up converter (8) configured to generate the driver supply voltage (U2) from a step-up converter input voltage (U3), the level of said step-up converter input voltage (U3) not being sufficient to switch the power semiconductors to conductivity, wherein the step-up converter (8) includes at least one controllable switching means (9) having a control input (9a) and a switch output (9b), wherein the controllable switching means (9) has a galvanic isolation between control input (9a) and switch output (9b), wherein the oscillator signal (G1) is applied to the control input (9a).

2. Control unit (1) according to claim 1, **characterized in that** the controllable switching means (9) is an optocoupler.

3. Control unit (1) according to claim 1, **characterized in that** the controllable switching means (9) is a capacitive coupler or an inductive coupler.

4. Control unit (1) according to any of the preceding claims, **characterized in that** the control unit (1) is a power converter or a servo controller with a safe torque off function.

5. Control unit (1) according to any of the preceding claims, **characterized in that** the level of the driver supply voltage (U2) is between 12 V and 30 V and the level of the step-up converter input voltage (U3) is less than 10 V.

6. Control unit (1) according to any of the preceding claims, **characterized in that** the step-up converter is a boost converter.

7. Control unit (1) according to any of claims 1 to 5, **characterized in that** the step-up converter is a flyback converter.

## Revendications

1. Contrôleur (1) destiné à commander un moteur électrique (2), possédant :
- une pluralité de semiconducteurs de puissance (3, 4) destinés à générer des signaux d'excitation (U, V, W) pour le moteur électrique (2),
- une pluralité de circuits d'attaque (5, 6) qui sont configurés pour générer des signaux d'attaque (UG1, UG2) pour les semiconducteurs de puissance (3, 4), les circuits d'attaque (5, 6) étant alimentés au moyen d'une tension d'alimentation de circuit d'attaque (U2) dont la présence est la condition pour que les circuits d'attaque (5, 6) génèrent leur signal d'attaque (UG1, UG2) respectif avec un état qui commute un semiconducteur de puissance (3, 4) associé à l'état passant, et
- un oscillateur (7) qui est configuré pour générer un signal d'oscillateur (G1), l'oscillateur (7) étant alimenté au moyen d'une tension d'alimentation d'oscillateur (U1) dont la présence est la condition pour que l'oscillateur (7) génère le signal d'oscillateur (G1),
**caractérisé en ce que** le contrôleur (1) possède :
- un convertisseur élévateur (8) qui est configuré pour générer la tension d'alimentation de circuit d'attaque (U2) à partir d'une tension d'entrée de convertisseur élévateur (U3) dont le niveau est insuffisant pour commuter les semiconducteurs de puissance à l'état passant, le convertisseur élévateur (8) possédant au moins un moyen de commutation commandable (9) pourvu d'une entrée de commande (9a) et d'une sortie de commutation (9b), le moyen de commutation commandable (9) possédant une isolation galvanique entre l'entrée de commande (9a) et la sortie de commutation (9b), l'entrée de commande (9a) étant sollicitée par le signal d'oscillateur (G1).

2. Contrôleur (1) selon la revendication 1, **caractérisé en ce que** le moyen de commutation commandable (9) est un optocoupleur.

3. Contrôleur (1) selon la revendication 1, **caractérisé en ce que** le moyen de commutation commandable (9) est un coupleur capacitif ou un coupleur inductif.

4. Contrôleur (1) selon l'une des revendications précédentes, **caractérisé en ce que** le contrôleur (1) est un convertisseur de courant ou un servorégulateur doté d'une fonction de coupure de sécurité du couple (STO) .

5. Contrôleur (1) selon l'une des revendications précédentes, **caractérisé en ce que** la tension d'alimentation de circuit d'attaque (U2) possède un niveau compris entre 12 V et 30 V et la tension d'entrée de convertisseur élévateur (U3) possède un niveau inférieur à 10 V.

6. Contrôleur (1) selon l'une des revendications précédentes, **caractérisé en ce que** le convertisseur élévateur est un convertisseur amplificateur.

7. Contrôleur (1) selon l'une des revendications 1 à 5, **caractérisé en ce que** le convertisseur élévateur est un convertisseur bloqueur.
